# EUROPEAN PATENT APPLICATION

(11) **EP 2 709 146 A2**
(43) Date of publication of application: **19.03.2014**
(21) Application number: 13182994.7
(22) Date of filing: 04.09.2013
(51) Int. Cl.: H01L 21/67

(54) **Integrated tool for semiconductor manufacturing**

(30) Priority: 14.09.2012 US 201213619507
(71) Applicant: STMicroelectronics, Inc., Coppell, TX 75019 (US)
(72) Inventor: Zhang, John H, Altamont, NY 12009 (US)
(74) Representative: Style, Kelda Camilla Karen

(57) **Abstract**

An integrated tool to reduce defects in manufacturing a semiconductor device by reducing queue times during a manufacturing process. The integrated tool may include at least one a polishing tool comprising at least one polishing module and at once deposition tool comprising at once deposition chamber. At least one pump-down chamber may connect the polishing tool to the deposition tool. The at once pump-down chamber includes a through which the semiconductor device is passed. Defects in the semiconductor device are reduced by reducing the queue time at various stages of the fabrication process.

## Description

### BACKGROUND

Semiconductor devices may be manufactured using a variety of tools, such as deposition tools and chemical mechanical polishing (CMP) tools. Deposition tools may be used to add material to the device, while CMP tools may be used to remove material from the device. During manufacturing, the device may need to pass between one or more CMP tools and one or more deposition tools several times. Each time a transfer is made from a first tool to a second tool, there is a queue time associated with that transfer. The queue time is the duration of time that the device waits without being processed by any of the tools.

It may be the case that two tools that are to be used for consecutive steps of a manufacturing process are a large distance apart. The device being manufactured is then transported from the first tool to the second tool for the process to continue. The time it takes to transport the device from the first tool to the second tool can greatly increase the queue time.

Over the years, semiconductor devices have been designed for faster switching speeds and greater functionality. An approach to achieving devices with these capabilities has been to decrease the size of features within the semiconductor devices. Another approach for achieving desirable semiconductor device performance is to use different materials. Ultra-low dielectric (ULK) are known to be used for this purpose.

### SUMMARY

The inventor has recognized that certain defects in a semiconductor device, including those with small feature size and ultra-low dielectric materials, may arise due to an extended queue time between steps of the manufacturing process. Accordingly, described herein are techniques for reducing the queue time for semiconductor devices undergoing the manufacturing process.

Various tools used in the manufacturing process may be integrated into a single integrated tool. By using a single integrated tool, the duration of the queue time at various stages of the process may be reduced.

Some embodiments are directed to an integrated tool to reduce defects in manufacturing a semiconductor device include a polishing tool with at least one polishing module and a first deposition tool with at least one deposition chamber. At least one pump-down chamber connects the polishing tool to the deposition tool. The at least one pump-down chamber includes a passage through which the semiconductor device is passed. At least one transfer mechanism passes the semiconductor device through the passage and into the at least one pump-down chamber. In some embodiments, the first deposition tool may include a chemical vapor deposition (CVD) tool and/or a physical vapor deposition (PVD) tool and the at least one deposition chamber may include a CVD chamber. The first deposition tool may include a buffer chamber.

The integrated tool may also include at least one additional deposition tool with at least one deposition chamber. The at least one additional deposition tool may include a CVD tool and/or a PVD tool. The at least one additional deposition tool may include a buffer chamber that is coupled to the buffer chamber of the first deposition tool. The coupling may be a direct connection or it may include one or more additional chambers, such as an additional pump-down chamber. In some embodiments, the at least one deposition tool is a plurality of tools. The plurality of tools may include a second and third deposition tool. Both the second and the third deposition tool may be either directly connected to the first deposition tool or coupled to the first deposition tool via an additional pump-down chamber.

In some embodiments, the integrated tool may comprise a backup load lock that is connected to the at least one additional pump-down chamber. The at least one pump down chamber and the at least one additional pump-down chamber may comprise a plurality of pump-down chambers.

Some embodiments are directed to a method of manufacturing a semiconductor device. The method may include polishing the semiconductor device in a polishing tool and depositing at least a first material onto the semiconductor device in a first deposition tool. These acts may be performed in any suitable order, and the semiconductor device may be moved between the polishing tool and the deposition tool within an integrated tool.

In some embodiments, the semiconductor device being manufactured has technology nodes of 20 nm or less. The first material deposited may have an ultra-low dielectric constant. Such a material is referred to as an ultra-low k (ULK) material. The defects in the semiconductor device may be reduced by reducing a time duration between polishing the semiconductor device and depositing the first material.

A second material may be deposited onto the semiconductor device in a second deposition tool. The defects in the semiconductor device are reduced in some embodiments by reducing a time duration between depositing the first material and depositing the second material. The first material may form a metal liner and the second layer may form a metal film. In some embodiments, the first deposition tool may be a CVD tool and the second deposition tool may be a PVD tool.

In some embodiments, the method of manufacturing the semiconductor device includes moving the semiconductor device between the first deposition tool and the second deposition tool within the integrated tool. Moving the semiconductor device between the first deposition tool and the second deposition tool may include moving the semiconductor device into a pump down chamber of the integrated tool. Also, moving the semiconductor device between the CMP tool and the deposition tool may include moving the semiconductor device into a pump down chamber of the integrated tool.

An integrated tool to reduce defects in manufacturing a semiconductor device, the integrated tool may comprise a polishing tool comprising at least one polishing module; a first deposition tool comprising at least one deposition chamber; at least one pump-down chamber connecting the polishing tool to the deposition tool, the at least one pump-down chamber comprising a passage through which the semiconductor device is passed; and at least one transfer mechanism to pass the semiconductor device through the passage and into the at least one pump-down chamber.

The first deposition tool may comprise a chemical vapor deposition (CVD) tool; and the at least one deposition chamber is a CVD chamber.

At least one additional deposition tool may comprise at least one deposition chamber; wherein the first deposition tool comprises a buffer chamber; the at least one additional deposition tool comprises a buffer chamber; and the buffer chamber of the at least one additional deposition tool is coupled to the buffer chamber of the first deposition tool.

The first deposition tool may comprise a chemical vapor deposition (CVD) tool; and the at least one additional deposition tool comprises a physical vapor deposition (PVD) tool.

The buffer chamber of the at least one additional deposition tool may be directly connected to the buffer chamber of the first deposition tool.

The buffer chamber of the at least one additional deposition tool may be coupled to the buffer chamber of the first deposition tool via at least one additional pump-down chamber.

The at least one additional deposition tool may be a plurality of deposition tools comprising at least a second deposition tool and a third deposition tool.

The second deposition tool may be directly connected to the first deposition tool or coupled to the first deposition tool via at least a first additional pump-down chamber; and the third deposition tool may be directly connected to the first deposition tool or coupled to the first deposition tool via at least a second additional pump-down chamber.

The integrated tool may further comprise a backup load lock directly connected to the at least one additional pump-down chamber.

The at least one pump-down chamber may comprise a plurality of pump-down chambers.

A method of manufacturing a semiconductor device, the method may comprise polishing the semiconductor device in a polishing tool; depositing a first material onto the semiconductor device in a deposition tool; and moving the semiconductor device between the polishing tool and the deposition tool within an integrated tool.

The semiconductor device may have technology nodes of 20 nm or less.

The first material deposited may be an ultra-low k (ULK) material.

The defects in the semiconductor device may be reduced by reducing a time duration between polishing the semiconductor device and depositing the first material.

The deposition tool may be a first deposition tool, the method further comprising depositing a second material onto the semiconductor device in a second deposition tool; wherein the defects in the semiconductor device are reduced by reducing a time duration between depositing the first material and depositing the second material.

The first material may form a metal liner; and the second material forms a metal film.

The method may further comprise moving the semiconductor device between the first deposition tool and the second deposition tool within the integrated tool.

The first deposition tool may be a chemical vapor deposition (CVD) tool; and the second deposition tool is a physical vapor deposition (PVD) tool.

Moving the semiconductor device between the first deposition tool and the second deposition tool may comprise moving the semiconductor device into a pump down chamber of the integrated tool.

Moving the semiconductor device between the polishing tool and the deposition tool may comprise moving the semiconductor device into a pump down chamber of the integrated tool.

The foregoing is a non-limiting summary of the invention, which is defined by the attached claims.

### BRIEF DESCRIPTION OF DRAWINGS

The accompanying drawings are not intended to be drawn to scale. In the drawings, each identical or nearly identical component that is illustrated in various figures is represented by a like numeral. For purposes of clarity, not every component may be labeled in every drawing. In the drawings:
FIG. 1 is a block diagram of an exemplary integrated tool illustrating a single polishing tool and a single deposition tool;
FIG. 2 is a block diagram of an exemplary integrated tool illustrating a single polishing tool and two deposition tools;
FIG. 3 is a block diagram of an exemplary integrated tool illustrating a single polishing tool and three deposition tools; and
FIG. 4 is a flow chart illustrating a process of manufacturing a semiconductor device according to some embodiments.

### DETAILED DESCRIPTION

The inventor has recognized and appreciated that integrating metal and ultra-low k (ULK) materials, i.e., materials with an ultra-low dielectric constant, in a semiconductor device becomes increasingly challenging as the size of the device being manufactured decreases. As feature sizes of devices are decreased, defects hinder the performance of the devices resulting in higher failure rates than devices with larger features. These defects either do not occur in devices with larger features or do not impact the performance of these devices. In particular, defects become particularly problematic when technology nodes of the semiconductor device are 20 nm apart or less.

The inventor has further recognized and appreciated that one of the causes of the defects is the amount of time that a semiconductor waits between steps in the manufacturing process, known as the queue time. The inventor has recognized and appreciated that longer queue times result in devices that fail more often and fail more quickly than devices with shorter queue times. Without being bound by any particular theory, the inventors theorize that the increased failure rate is the result of moisture affecting the dielectric layers and increasing the likelihood of time dependent dielectric breakdown (TDDB).

The inventor has recognized and appreciated that the queue time may be reduced by performing the manufacturing process of the semiconductor device in an integrated tool comprising multiple tools. For example, the integrated tool may include a chemical vapor deposition (CVD) tool, a physical vapor deposition (PVD) tool, and/or a chemical mechanical polishing (CMP) tool. The tools of the integrated tool are coupled either via a direct connection or via a pump-down chamber.

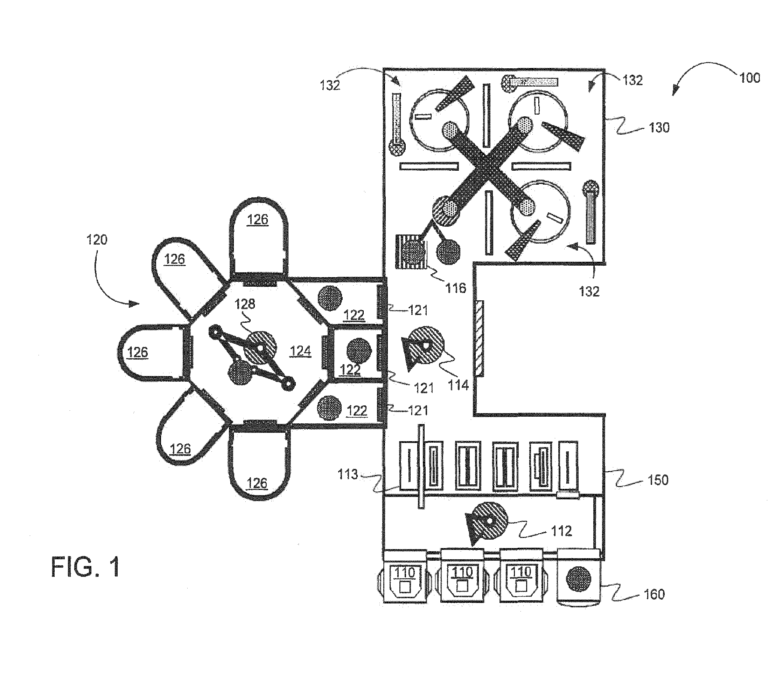

FIG. 1 is a block diagram illustrating one possible embodiment of an integrated tool 100. The integrated tool 100 comprises a deposition tool 120 and a CMP tool 130. The integrated tool 100 may also include various other tools, such as cleaning tool 150 and inline metrology tool 160.

Semiconductor devices being manufactured by integrated tool 100 are loaded into the tool via load lock 110. Any suitable number of load locks 110 may be used. For example, FIG. 1 illustrates three load locks 110. Any suitable number of semiconductor devices may be loaded into load lock 110 at a time. For example, a single wafer may comprise a plurality of semiconductor devices. Moreover, a cassette occupied by a plurality of wafers may be loaded into load lock 110.

The semiconductor device being loaded into load lock 110 may be at any stage of the manufacturing process. For example, the manufacturing process may be segregated into two portions, referred to as front end of line (FEOL) and back end of line (BEOL). FEOL refers to the first portion of device fabrication where individual elements of the device are patterned in the semiconductor. BEOL refers to the second portion of device fabrication where the individual elements of the device are interconnected. The integrated tool 100, in some embodiments, is responsible for only the BEOL processing. However, embodiments are not so limited.

Once the semiconductor device is loaded into load lock 110, a transfer mechanism 112 is used to remove the semiconductor device from load lock 110. Any suitable transfer mechanism 112 may be used. For example, transfer mechanism 112 may be a robot arm. However, other transfer mechanisms may be used, such as a vacuum hose that holds the semiconductor device using suction or a conveyor. More than one transfer mechanism may be used. For example, as illustrated in FIG. 1, transfer mechanism 112 may pass the semiconductor device through a passage 113 to a second transfer mechanism 114. Depending on which tool is to be used first, transfer mechanism 114 may pass the semiconductor device to deposition tool 120 or CMP tool 130.

CMP tool 130 comprises a plurality of CMP modules 132. Techniques for performing CMP are known and embodiments are not limited to any particular implementation of CMP. For the sake of clarity, the individual components of each CMP module 132 are not labeled with reference numbers. However, one of skill in the art would recognize that each CMP module 132 may comprise components such as a slurry dispersion arm, a condition arm, a condition disk, a platen, a platen process window and a CMP head. The CMP module 132 and the components thereof may be constructed using techniques known in the art. The semiconductor device may be processed by each of the plurality of CMP modules 132 in turn. For example, each CMP module 132 may use different parameters in performing CMP. The parameters that may be varied include, but are not limited to, the rotation speed of the platen, the rate of slurry dispersion, the duration, and the pressure.

CMP tool 130 may also comprise a transfer mechanism 116 for receiving the semiconductor device from transfer mechanism 114 and providing the semiconductor device to the CMP head of one of the CMP modules 132.

Though a CMP tool is described herein, embodiments are not so limited. Any suitable polishing tool may be used. For example, a free abrasive polishing tool or a chemical etching tool may be used.

Deposition tool 120 may include a plurality of deposition chambers 126, a buffer chamber 124, and transfer mechanism 128 for receiving the semiconductor device and providing the semiconductor device to the deposition chambers 126. Each chamber may deposit a different material using different techniques, or the same material and techniques may be used in each of the deposition chambers 126. For example, the material being deposited may be an insulator or a metal. The deposited material may also be a mix of more than one material. The deposition tool 120 may be used for performing, for example, chemical vapor deposition (CVD) or physical vapor deposition (PVD). Techniques for CVD in PVD are known in the art and embodiments are not limited to any particular technique for performing CVD and/or PVD.

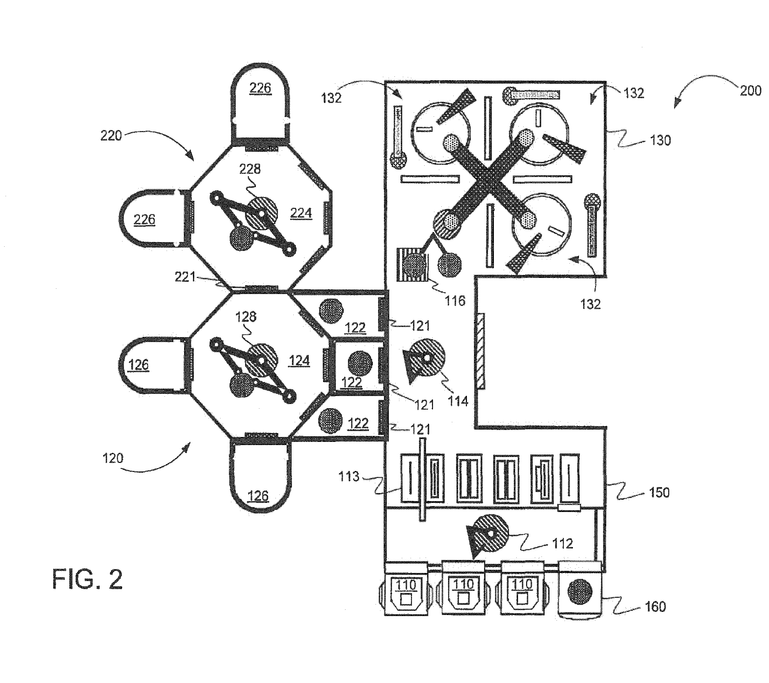

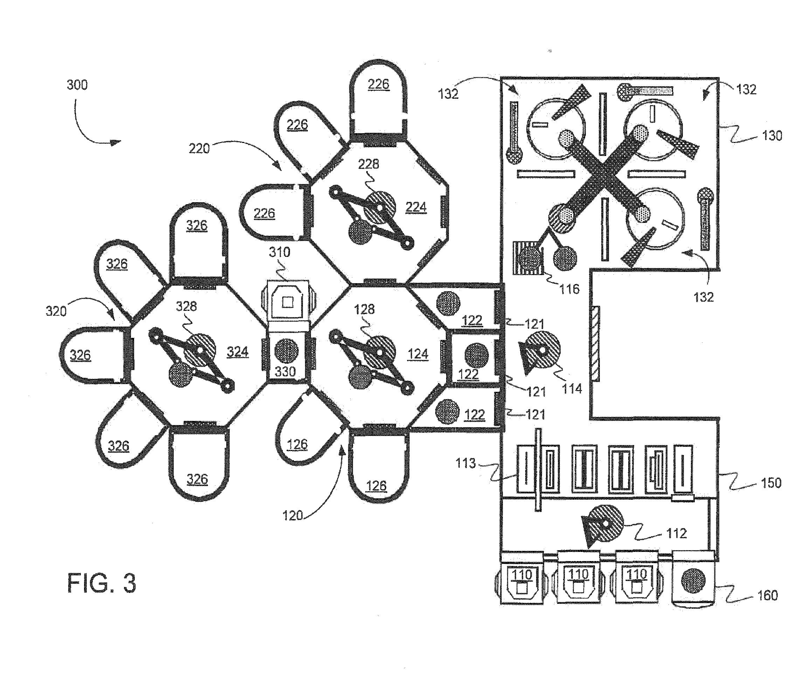

The deposition tool 120 may have any number of deposition chambers 126. FIG. 1 illustrates deposition tool 120 with five deposition chambers 126. However, some embodiments may use fewer deposition chambers. For example, as will be discussed in more detail in connection with FIG. 2 and FIG. 3,it may be advantageous for deposition tool 120 to have only two or three deposition chambers 126. This may enable additional tools to be included in integrated tool 100.

In some embodiments, the deposition tool 120 may deposit an ultra-low k (ULK) dielectric material onto the semiconductor device. A material may be classified as an ULK material if the dielectric constant of the material is 2.55 or less. Furthermore, in some embodiments, the semiconductor device may have technology nodes that are 20 nm apart or less. The technology nodes may be individual elements of the semiconductor device that may be patterned in an array.

Buffer chamber 128 of deposition tool 120 may be maintained at a decreased pressure via, for example, a vacuum pump. Buffer chamber 124 may help prevent possible contamination from materials used in each of the deposition chambers 126 by ensuring any of said materials are evacuated and not allowed to come in contact with the semiconductor device being fabricated after it moves into another chamber 126.

Deposition tool 120 may be coupled to the CMP tool 130 by any suitable means. For example, the deposition tool 120 may be connected to the CMP tool 130 via at least one pump-down chamber 122. FIG. 1 illustrates an embodiment with three pump-down chambers 122. However, embodiments of the invention are not limited to any particular number of pump-down chambers 122. For example, a single pump-down chamber 122 may be used. An advantage of using a plurality of pump-down chambers 122 is the ability to perform steps of the fabrication process in parallel. For example, a first semiconductor device could be loaded into a first pump-down chamber 122 from the CMP tool 130, while a second semiconductor device is being loaded into a second pump-down chamber 122 from the deposition tool 120.

Pump-down chambers 122 comprise at least one passage 121 through which the semiconductor device is passed by the transfer mechanism 114. Upon receiving the semiconductor device in the pump-down chamber 122, the pressure of the pump-down chamber 122 is decreased using, for example, a vacuum pump.

During fabrication of the semiconductor device in integrated tool 100, the device may be transferred back and forth between the deposition tool and the CMP tool several times. For example, one or more layers of at least one material may be deposited on the semiconductor device in deposition tool 120, followed by the removal of at least a portion of the one or more layers in the CMP tool 130. Upon completion of the planarization by the CMP tool, additional layers may be deposited on the semiconductor device using deposition tool 120. Each time that the semiconductor device is transferred between the tools, the device is passed through pump-down chambers 122. The number of times that a semiconductor device is passed between the tools of the integrated tool 100 depends on the specific type device being fabricated. Embodiments are not limited to use with any particular type of device and, therefore, the semiconductor device may be processed by each tool any suitable number of times and transferred between the tools of the integrated tool 100 any suitable number of times. Furthermore, processing the semiconductor device using the integrated device may be done in any suitable order.

The integrated tool 100 may also comprise additional tools. For example, cleaning tool 150 and an inline metrology tool 160 may be included in the integrated tool. Because the CMP tool implements a wet process, the cleaning tool 150 may clean the semiconductor device before the manufacturing process is complete. Inline metrology tool 160 may be used at various stages of the manufacturing process to measure various properties of the semiconductor device and/or the wafer. For example, the inline metrology tool 160 may be an eddy current measurement tool used to measure properties of a metallic layer of the semiconductor device. However, the inline metrology tool 160 is not limited to any particular metrology technique. For example, the inline metrology tool 160 may utilize one or more Kelvin probe force microscopes to measure the semiconductor device's surface charge profile and/or height profile.

The semiconductor device may be transferred between the various tools, such as the cleaning module 150 and/or the inline metrology tool 160 using one or more transfer mechanisms 112 and 114. Furthermore, embodiments are not limited to using any of the tools of the integrated tool 100 at any particular stage of the manufacturing process. For example, the cleaning module 150 may be used only at the very end of the manufacturing process. However, there may be situations where the cleaning module 150 may be used during an intermediate step of the fabrication process.

By integrating the various tools of integrated tool 100, the queue times for the semiconductor device be significantly reduced thereby reducing the cost by reducing the number of defects.

FIG. 2 is a block diagram illustrating an additional embodiment of an integrated tool 200. Many components of integrated tool 200 are similar or identical to the components of integrated tool 100. Accordingly, similar components are labeled with identical reference numbers as described above in connection with FIG. 1. Furthermore, the above description of the components of integrated tool 100 applies to the similar components of integrated tool 200. Accordingly, the above description will not be duplicated, but is instead incorporated here by reference.

As described above, integrated tool 200 comprises one CMP tool 130 and a deposition tool 120. Deposition tool 120 comprises two deposition chambers 126. Instead of including more deposition chambers 126, integrated tool 200 includes an additional deposition tool 220 coupled to deposition tool 120. The two deposition tools may be coupled in any suitable way. For example, the two tools may be directly connected via passage 221. However, additional tools and/or chambers may be used to couple deposition tool 120 to deposition tool 220. For example, an additional pump-down chamber (not shown in FIG. 2) may be placed between the two deposition tools. Moreover, a third deposition tool may be placed between deposition tool 120 and deposition tool 220.

The additional deposition tool 220 may include one or more deposition chambers 226, a buffer chamber 224, and transfer mechanism 228. Any suitable deposition tool 220 may be used. For example, deposition tool 220 may be the same type as deposition tool 120 or the two deposition tools may be of different types. For example, deposition tool 120 may be a CVD tool and deposition tool 220 may be a PVD tool. Similarly, buffer chamber 224 and buffer chamber 124 may be maintained at the same pressure or different pressures. For example, buffer chamber 120 may be maintained at a first pressure that is higher than the second pressure at which buffer chamber 224 is maintained.

If deposition tool 220 is a PVD tool and deposition tool 120 is a CVD tool integrated tool 200 is provided with increased flexibility, allowing for the fabrication of a wider variety of semiconductor devices.

FIG. 3 is a block diagram illustrating an additional embodiment of an integrated tool 300. Many components of integrated tool 300 are similar or identical to the components of integrated tools 100 and 200. Accordingly, similar components are labeled with identical reference numbers as described above in connection with FIG. 1 and FIG. 2. Furthermore, the above description of the components of integrated tools 100 and 200 applies to the similar components of integrated tool 200. Accordingly, the above description will not be duplicated, but is instead incorporated here by reference.

As described above, integrated tool 300 comprises one CMP tool 130, a first deposition tool 120 and a second deposition tool 220. The first deposition tool 120 comprises two deposition chambers 126 and the second deposition tool 220 comprises three deposition chambers 226. Integrated tool 300 also includes a third deposition tool 320 coupled to first deposition tool 120. The two deposition tools may be coupled in any suitable way. For example, the two tools may be directly connected via a passage. However, additional tools and/or chambers may be used to couple first deposition tool 120 to third deposition tool 320. For example, an additional pump-down chamber 330 may be placed between the first deposition tool 120 and third deposition tool 320. Moreover, an additional deposition tool may be placed between first deposition tool 120 and third deposition tool 320. For example, third deposition tool 320 may be coupled to first deposition tool 120 via the second deposition tool 220.

The third deposition tool 320 may include one or more deposition chambers 326, a buffer chamber 324, and transfer mechanism 328. Any suitable deposition tool 320 may be used. For example, third deposition tool 320 may be the same type as first deposition tool 120 or second deposition tool 220, or the two deposition tools may be of different types. For example, first deposition tool 120 may be a CVD tool and second deposition tool 220 may be a PVD tool. The third deposition tool 320 may be either a CVD tool or a PVD tool. Similarly, buffer chamber 324 and buffer chambers 124 and 224 may be maintained at the same pressure or different pressures. For example, buffer chamber 120 may be maintained at a first pressure that is higher than the second pressure at which buffer chambers 224 and 324 are maintained.

In some embodiments, third deposition tool 320 and first deposition tool 120 may both be a CVD tool. However, the material deposited on the semiconductor device may be different. For example, first deposition tool 120 may be used to deposit metal on the semiconductor device and third deposition tool 320 may be used to deposit an insulating material on the semiconductor device. Moreover, the second deposition tool 220 may be a PVD tool that deposits a metal liner onto the semiconductor device. In such a configuration the integrated tool 300 is provided with increased flexibility, allowing for the fabrication of a wider variety of semiconductor devices.

In some embodiments, integrated tool 300 may include one or more back up load locks 310. FIG. 3 illustrates a single backup load lock 310, but any number of backup load locks may be used. Backup load lock 310 allows the semiconductor device to be removed from the integrated tool at a point other than load locks 110. This may be advantageous in a case where the semiconductor device needs to be brought to a tool outside of integrated tool 300 for processing. Moreover, in the case where one or more of the deposition chambers is malfunctioning or down for maintenance, the backup load lock 310 may be used to transfer the semiconductor device to an external deposition chamber to perform the necessary fabrication steps.

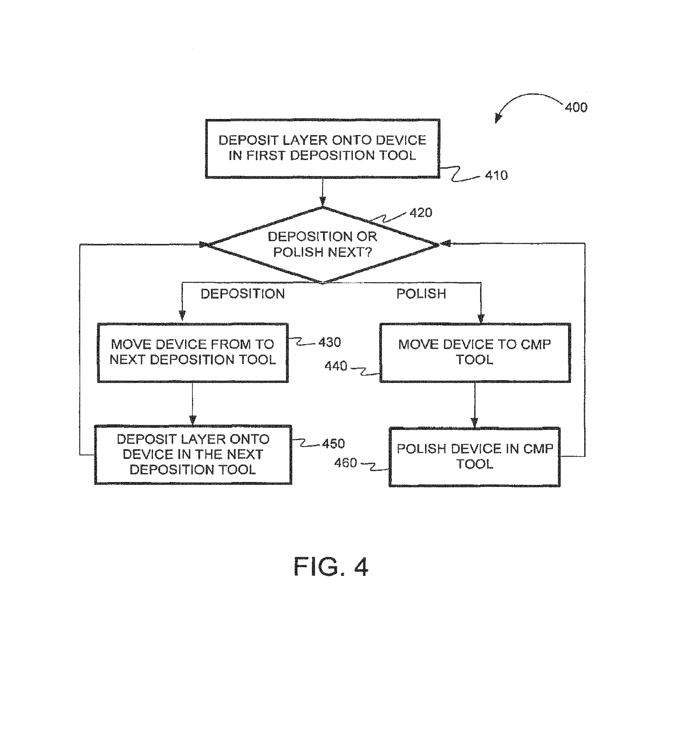

FIG. 4 is a flow chart illustrating a process 400 of manufacturing a semiconductor device according to some embodiments. At act 410, a first layer of a first material is deposited onto the semiconductor device in a first deposition tool of the integrated tool. The first material may be any suitable material, such as a metal or an insulator. An insulating material may be an ULK material. The first layer may be deposited in a suitable way. For example, it may be deposited using a CVD tool or a PVD tool.

At act 420, it is determined whether the next act in the manufacturing process is depositing a next layer or polishing the semiconductor device. This determination may be done in any suitable way. For example, the integrated tool may use a recipe or program set by a user of the integrated tool. The recipe may determine the order in which the tools are used. The recipe may also specify parameters to be used by each of the tools.

If it is determined that the next act is a depositing act, the semiconductor device may be moved to the next deposition tool at act 430. If the next deposition tool is the same tool that was used to deposit the first layer in act 410, then it may be unnecessary to transfer the semiconductor device. However, even if the same deposition tool is used at act 430, the semiconductor device may need to be passed to a different deposition chamber of the deposition tool.

After the semiconductor device has been moved to the next deposition tool, a next layer is deposited on the semiconductor device in the deposition tool at act 450. Again, this deposition act may be performed in any suitable way. For example, the next layer may be deposited using a CVD tool or a PVD tool. After completion of act 450, process 400 returns to act 420 to determine whether the next act is a deposition act or a polishing act.

If, at act 420, it is determined that the next act is a polishing act, the semiconductor device is moved to the CMP tool to undergo polishing. The polishing of the semiconductor device is performed at act 460. Any suitable CMP technique may be used to polish the semiconductor device. For example, a variety of parameters, such as a time duration, a pressure, the slurry flow rate, and a platinum rotation speed, may be used to control the CMP tool.

In some embodiments, prior to moving the semiconductor device to the CMP tool at act 440, the semiconductor device may be moved to the inline metrology tool to measure various properties of the semiconductor device. The results of the measurement may be used to tailor the parameters of the CMP tool used in the polishing act 460.

Acts 430 and 440, where the semiconductor device is moved between the tools of the integrated tool, may be performed in any suitable way. For example, they may be performed by transfer mechanisms 112, 114, 124, 224, 324, 116, or any other transfer mechanism. By incorporating the various tools used in the semiconductor manufacturing process into a single integrated tool, the number of defects that result in failure in operation of the completed semiconductor device may be reduced by reducing the queue time between each step of the semiconductor manufacturing process.

For example, in some embodiments, a metal liner may be deposited on the semiconductor device using a PVD tool. The following act of the manufacturing process may be depositing a metal film over the metal liner. The queue time between the act of depositing the metal liner and depositing the metal film may be an important time duration to reduce. If this queue time increases, the likelihood of failure of completed semiconductor device may also increase.

After depositing the metal film, the next act may be a polishing act to remove portions of the metal film and planarize the semiconductor device. After the planarization of the semiconductor device, the next act may include depositing an insulating layer over the portions of the metal film remain. The queue time between the act of polishing the metal film and depositing the insulating layer may be an important time duration to reduce. If this queue time increases, the likelihood of failure of completed semiconductor device may also increase.

The above embodiments of the invention are described with reference to a CMP tool and deposition tools. Embodiments are not so limited. Any other semiconductor fabrication tool may be incorporated into the integrated tool. For example, etching tools, such as a reactive ion etching (RIE) tool, thermal tools, such as annealing furnaces, ion implantation tools, and photolithography tools may be included in the integrated tool.

This invention is not limited in its application to the details of construction and the arrangement of components set forth in the foregoing description or illustrated in the drawings. The invention is capable of other embodiments and of being practiced or of being carried out in various ways. Also, the phraseology and terminology used herein is for the purpose of description and should not be regarded as limiting. The use of "including," "comprising," or "having," "containing," "involving," and variations thereof herein, is meant to encompass the items listed thereafter and equivalents thereof as well as additional items.

Various aspects of the present invention may be used alone, in combination, or in a variety of arrangements not specifically discussed in the embodiments described in the foregoing and is therefore not limited in its application to the details and arrangement of components set forth in the foregoing description or illustrated in the drawings. For example, aspects described in one embodiment may be combined in any manner with aspects described in other embodiments.

Also, the invention may be embodied as a method, of which at least one example has been provided. The acts performed as part of the method may be ordered in any suitable way. Accordingly, embodiments may be constructed in which acts are performed in an order different than illustrated, which may include performing some acts simultaneously, even though shown as sequential acts in illustrative embodiments.

Use of ordinal terms such as "first," "second," "third," etc., in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

Having thus described several aspects of at least one embodiment of this invention, it is to be appreciated that various alterations, modifications, and improvements will readily occur to those skilled in the art. Such alterations, modifications, and improvements are intended to be part of this disclosure, and are intended to be within the spirit and scope of the invention. Accordingly, the foregoing description and drawings are by way of example only.

## Claims

1. An integrated tool, the integrated tool comprising:
a polishing tool comprising at least one polishing module;
a first deposition tool comprising at least one deposition chamber;
at least one pump-down chamber connecting the polishing tool to the deposition tool, the at least one pump-down chamber comprising a passage through which the semiconductor device is passed; and
at least one transfer mechanism to pass the semiconductor device through the passage and into the at least one pump-down chamber.

2. The integrated tool of claim 1, wherein:
the first deposition tool comprises a chemical vapor deposition (CVD) tool; and
the at least one deposition chamber is a CVD chamber.

3. The integrated tool of claim 1 or 2, further comprising:
at least one additional deposition tool comprising at least one deposition chamber;
wherein:
the first deposition tool comprises a buffer chamber;
the at least one additional deposition tool comprises a buffer chamber; and
the buffer chamber of the at least one additional deposition tool is coupled to the buffer chamber of the first deposition tool.

4. The integrated tool of claim 3, wherein:
the buffer chamber of the at least one additional deposition tool is directly connected to the buffer chamber of the first deposition tool.

5. The integrated tool of claim 3 or 4, wherein:
the buffer chamber of the at least one additional deposition tool is coupled to the buffer chamber of the first deposition tool via at least one additional pump-down chamber.

6. The integrated tool of any of claims 3 to 5, wherein:
the at least one additional deposition tool is a plurality of deposition tools comprising at least a second deposition tool and a third deposition tool;
the second deposition tool is directly connected to the first deposition tool or coupled to the first deposition tool via at least a first additional pump-down chamber; and
the third deposition tool is directly connected to the first deposition tool or coupled to the first deposition tool via at least a second additional pump-down chamber.

7. The integrated tool of claim 5 or 6, further comprising:
a backup load lock directly connected to the at least one additional pump-down chamber.

8. A method of manufacturing a semiconductor device, the method comprising:
polishing the semiconductor device in a polishing tool;
depositing a first material onto the semiconductor device in a deposition tool; and
moving the semiconductor device between the polishing tool and the deposition tool within an integrated tool.

9. The method of claim 8, wherein the semiconductor device has technology nodes of 20 nm or less.

10. The method of claim 8 or 9, wherein the first material deposited is an ultra-low k (ULK) material.

11. The method of claim 8, 9 or 10, wherein the deposition tool is a first deposition tool, the method further comprising:
depositing a second material onto the semiconductor device in a second deposition tool;
wherein:

12. The method of claim 11, wherein:
the first material forms a metal liner; and
the second material forms a metal film.

13. The method of claim 11 or 12, method further comprising:
moving the semiconductor device between the first deposition tool and the second deposition tool within the integrated tool.

14. The method of any of claims 8 to 13, wherein:
moving the semiconductor device between the tools comprises moving the semiconductor device into a pump down chamber of the integrated tool.

15. A tool or method of any preceding claim, wherein:
the first deposition tool is a chemical vapor deposition (CVD) tool; and
the second or the at least one further deposition tool is a physical vapor deposition (PVD) tool.
